# FASCICULE DE BREVET EUROPEEN

(11) **EP 0 409 693 B1**
(45) Date de publication et mention de la délivrance du brevet: **22.09.1993**
(21) Numéro de dépôt: 90401979.1
(22) Date de dépôt: 09.07.1990
(51) Int. Cl.: C23C 16/40, G21C 3/18

(54) **Procédé de réalisation d'une couche d'isolation en oxyde de chrome entre les pastilles et la gaine d'un élément combustible nucléaire et élément combustible comportant une telle couche d'isolation**
Verfahren zur Herstellung einer Chromoxidschutzschicht zwischen den Tabletten und dem Kühlrohr eines Kernbrennelements und Kernbrennelement mit einer solchen Schutzschicht
Method of obtaining an insulating coating of chromium oxide between the pellets and the cladding of a nuclear fuel element and nuclear fuel element having such an insulating coating

(30) Priorité: 21.07.1989 FR 8909891
(43) Date de publication de la demande: 23.01.1991
(73) Titulaire: FRAMATOME, 92400 Courbevoie (FR); COGEMA, F-78141 Velizy Villacoublay (FR)
(72) Inventeur: Hertz, Dominique, F-69160 Tassin-La-Demi-Lune (FR); Audisio, Sylvain, F-69300 Caluire (FR); Defoort, Françoise, F-69001 Lyon (FR); Idrissi, Hassan, F-69001 Lyon (FR)
(74) Mandataire: Bouget, Lucien

(56) Documents cités:
- EP-A- 0 055 459
- EP-A- 0 204 565
- EP-A- 0 264 820
- FR-A- 1 556 428
- US-A- 3 852 098
- SOVIET PHYSICS TECHNICAL PHYSICS, vol. 29, no. 6, juin 1984, page 692, New York, US; A.S. IVANTSEV et al.: "Color characteristics of pyrolytic metal oxide films"

## Description

L'invention concerne un procédé de réalisation d'une couche d'isolation en oxyde de chrome entre les pastilles et la gaine d'un élément combustible d'un réacteur nucléaire refroidi à l'eau et un élément combustible comportant une telle couche d'isolation.

Les éléments combustibles des réacteurs nucléaires refroidis à l'eau sont généralement constitués par des pastilles frittées en oxyde d'uranium ou de plutonium empilées à l'intérieur d'une gaine tubulaire en un alliage tel que le Zircaloy 2 ou le Zircaloy 4 qui sont des alliages à base de zirconium renfermant de l'étain.

Le gainage de l'élément combustible permet entre autres d'éviter un contact direct entre le fluide de refroidissement du réacteur et les pastilles de combustible frittées.

Le matériau de gainage doit donc résister à la corrosion par le fluide de refroidissement qui, dans le cas des réacteurs nucléaires à eau sous pression, est constitué par de l'eau renfermant différents additifs chimiques, à une température de l'ordre de 315°C et à une pression de 155 bars. Le matériau de gainage doit également présenter une faible capacité d'absorption des neutrons.

En outre, les pastilles de combustible nucléaire frittées subissent différentes transformations sous irradiation et en particulier un gonflement qui peut être responsable d'une forte pression de contact entre certaines pastilles de combustible et la surface intérieure de la gaine. La gaine subit en conséquence des contraintes mécaniques et se trouve exposée à des produits corrosifs engendrés lors de la transformation du combustible sous irradiation, dans les zones de contact entre la gaine et les pastilles. L'ensemble de ces phénomènes est généralement désigné sous l'appellation générale d'interaction pastilles-gaine (IPG).

Pour limiter les dégradations de la gaine provenant de l'interaction pastilles-gaine, on a proposé de réaliser la gaine sous forme composite, de manière qu'elle comporte une couche interne isolant le tube en alliage de zirconium des pastilles de combustible.

Un tel procédé est onéreux et difficile à mettre en oeuvre.

On a également proposé de réaliser différents revêtements de protection à l'intérieur de la gaine en alliage de zirconium, par des procédés classiques tels que le dépôt électrolytique de métaux. Ces procédés sont difficiles à mettre en oeuvre dans le cas de tubes dont le diamètre est voisin de 9 mm et la longueur supérieure à 4 mètres. En outre, la ténacité et l'efficacité des revêtements réalisés s'avèrent le plus souvent insuffisantes, lors de l'utilisation dans l'ambiance du réacteur nucléaire.

On connaît également des procédés de réalisation de revêtements connus sous le nom de dépot chimique à partir d'une phase gazeuse ou en anglais "chemical vapour deposition" ou CVD. Dans le cas où ces procédés sont utilisés pour déposer une couche d'un oxyde de métal sur un substrat, on met en contact un composé volatil du métal, en présence d'un gaz oxydant avec le substrat maintenu à une température permettant l'oxydation in situ du composé de métal.

C'est ainsi qu'on a proposé de réaliser des dépôts d'alumine, de zircone, de silice ou d'oxyde de chrome ou de hafnium, en utilisant un halogénure et généralement un chlorure comme composé gazeux.

Pour la mise en oeuvre de ces procédés, il est généralement nécessaire de maintenir le substrat à une température élevée de l'ordre de 1000°C. Cette exigence peut présenter certains inconvénients dans le cas des tubes de gainage pour éléments combustibles de réacteur nucléaire du fait de la sensibilité du zirconium aux halogénures et de la température qui modifie l'état métallurgique du métal de base.

On a également proposé de réaliser des dépôts d'oxyde de fer, d'indium ou d'étain ou encore des dépôts de zircone en utilisant un composé organo-métallique comme composé gazeux. Dans ce cas, le substrat peut être porté à une température nettement inférieure à 1000°C.

Dans tous les cas cependant, le dépôt d'oxyde sur le substrat est relativement lent et le revêtement devient extrêmement fragile dès que la couche déposée dépasse une certaine épaisseur, de l'ordre de 1 à 2 microns.

Il n'est donc pas possible d'obtenir par les procédés connus de l'art antérieur, des dépôts suffisamment épais et résistants pour assurer une protection efficace contre l'interaction pastilles-gaines dans les éléments combustibles des réacteurs nucléaires à eau sous pression.

De tels dépôts peuvent être constitués avantageusement par de l'oxyde de chrome sous forme de chromite Cr₂O₃.

On connaît des procédés de dépôt chimique à partir d'une phase gazeuse contenant un composé organométallique, qui peuvent être réalisés à une température modérée, nettement inférieure à 1000°C. De tels procédés n'ont cependant jamais été utilisés pour réaliser une couche d'isolation en oxyde de chrome entre les pastilles et la gaine d'un élément combustible pour réacteur nucléaire.

Le but de l'invention est donc de proposer un procédé de réalisation d'une couche d'isolation en oxyde de chrome entre les pastilles et la gaine d'un élément combustible pour réacteur nucléaire comportant une gaine en alliage de zirconium et un empilement de pastilles de matériau combustible fritté qui sont introduites dans la gaine, lors de la fabrication de l'élément combustible, ce procédé permettant de réaliser une couche d'isolation épaisse et résistante séparant de manière efficace et permanente les pastilles de la gaine de l'élément combustible.

Dans ce but, préalablement au remplissage de la gaine par les pastilles, on met en contact un composé organométallique de chrome sous forme gazeuse avec un substrat constitué par la surface intérieure de la gaine et/ou la surface extérieure des pastilles, en présence d'un gaz oxydant, pour réaliser le dépôt chimique en phase gazeuse d'oxyde de chrome sur le substrat maintenu à une température comprise entre 300 et 600°C.

De manière préférentielle, le composé organométallique est constitué par de l'acétylacétonate de chrome porté à une température de l'ordre de 200°C avant sa mise en contact avec le substrat, ce qui permet d'obtenir une pression partielle élevée du composé, dans la phase gazeuse.

L'invention concerne également un élément combustible tel que défini à la revendication 7

Afin de bien faire comprendre l'invention, on va maintenant décrire, à titre d'exemple non limitatif, en se référant aux figures jointes en annexe, un mode de réalisation du procédé suivant l'invention.

La figure 1 est une vue générale en perspective d'un dispositif permettant de réaliser le revêtement intérieur d'un tube de gainage d'un élément combustible.

La figure 2 est une vue schématique montrant la structure et le principe de fonctionnement du dispositif représenté sur la figure 1.

La figure 3 est un diagramme montrant les variations de la vitesse de croissance de la couche de revêtement en oxyde de chrome, en fonction de la température du substrat et pour deux températures différentes du composé de chrome sous forme de vapeur.

La figure 4 est un diagramme montrant les variations de la vitesse de croissance de la couche de revêtement en oxyde de chrome, en fonction de la température du substrat et pour une pression inférieure à la pression atmosphérique dans l'enceinte de réaction du dispositif de revêtement.

La figure 5 est un diagramme montrant les variations de la vitesse de croissance de la couche de revêtement en oxyde de chrome, en fonction de la température du composé organométallique de chrome.

Le substrat à revêtir par de l'oxyde de chrome est constitué par la surface intérieure d'un tube en alliage de zirconium (Zircaloy 4) dont le diamètre extérieur est de 9,5 mm et dont la longueur est supérieure à 4 mètres.

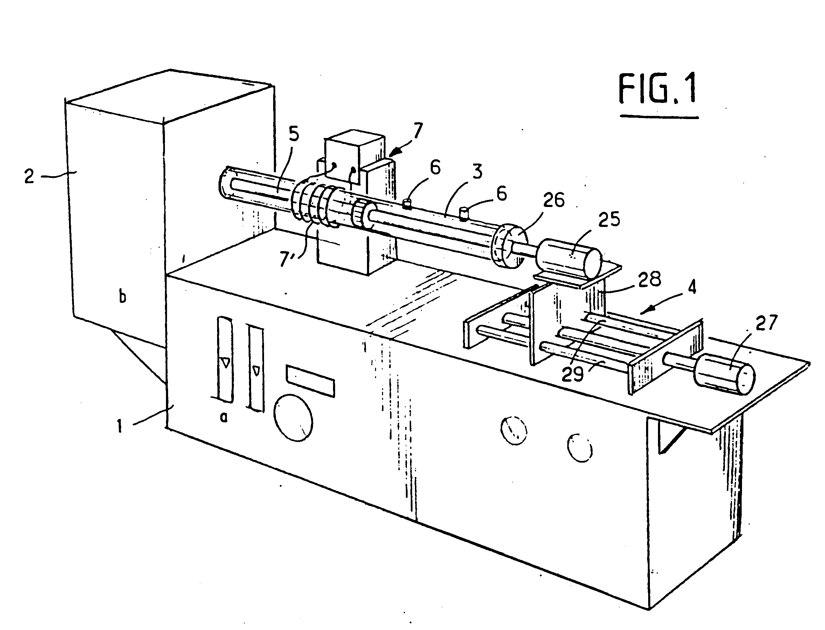

Comme il est visible sur la figure 1, le dispositif permettant d'effectuer le revêtement comporte un ensemble de support et de distribution de gaz 1, une étuve 2 dans laquelle sont réalisés la vaporisation et le maintien en température du composé organométallique de chrome, un tube de réaction 3 en verre réfractaire tel que du pyrex et un ensemble motorisé 4 permettant de réaliser le déplacement en rotation et en translation du tube 5 en Zircaloy placé à l'intérieur du réacteur en pyrex 3. Des ajutages 6 permettent d'évacuer les gaz résiduels pendant l'opération de revêtement.

Un dispositif de chauffage par induction 7 est placé sur le support 1 et comporte une bobine de chauffage 7' entourant le tube en pyrex 3 sur une certaine longueur correspondant à la zone de chauffage du tube 5 pendant l'opération de revêtement.

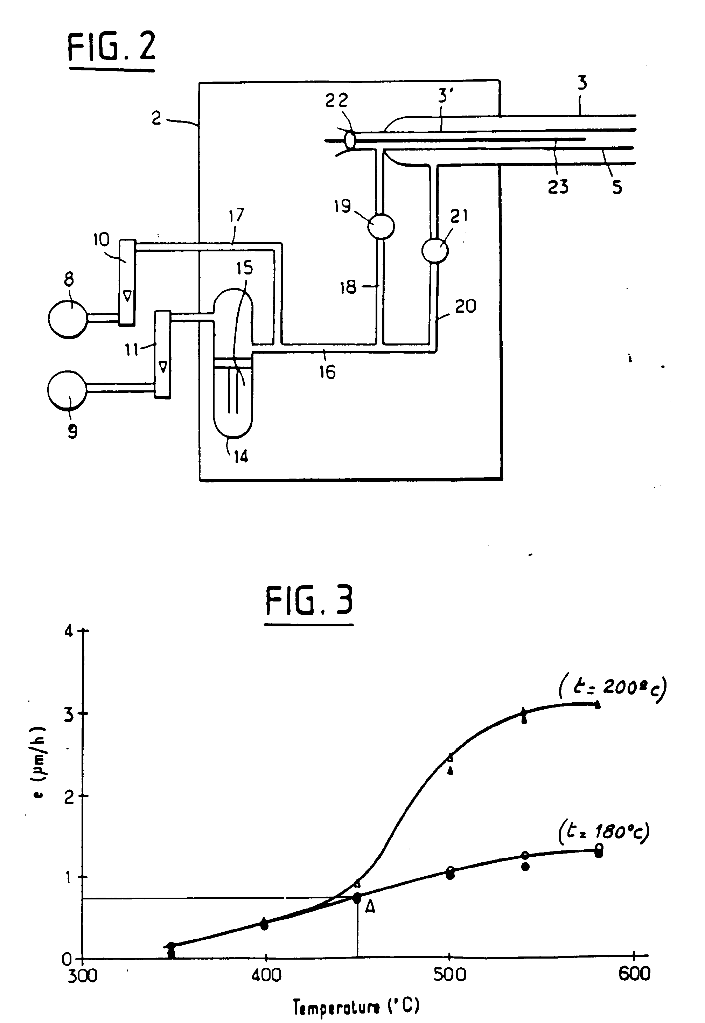

Comme il est visible sur les figures 1 et 2, l'ensemble de support et de distribution de gaz 1 comporte une source d'oxygène 8, une source d'argon 9, des débitmètres à billes 10 et 11 permettant d'assurer la distribution et la régulation du débit d'oxygène et d'argon ainsi que des canalisations de liaison.

La face avant de l'ensemble 1 de support et de distribution porte des moyens de commande et d'affichage permettant de régler et de contrôler les paramètres physiques relatifs à l'opération de revêtement.

Le dispositif de revêtement comporte de plus à l'intérieur de l'étuve 2, une ampoule 14 renfermant le composé organométallique de chrome 15 dont on réalise l'oxydation et la décomposition thermique. L'ampoule 14 est reliée à la source d'argon 9, par l'intermédiaire du débitmètre 11 et de canalisations de liaison. On peut réaliser ainsi un balayage du volume intérieur de l'ampoule 14 dans laquelle se produit la vaporisation du composé organométallique 15. Le mélange d'argon et de vapeur est évacué par une canalisation 16 dans laquelle un certain débit d'oxygène est envoyé depuis la source 8, par l'intermédiaire du débitmètre 10 et d'une canalisation 17.

Le mélange d'argon, d'oxygène et de vapeur de composé organométallique est envoyé dans le tube de pyrex 3 constituant le réacteur renfermant le tube 5 de Zircaloy, soit par l'intermédiaire d'une canalisation 18, soit par l'intermédiaire d'une canalisation 20, suivant l'état d'ouverture ou de fermeture de deux robinets 19 et 21 placés sur les canalisations 18 et 20 respectivement. Ce mélange gazeux est parfaitement homogène, le composé de chrome étant entièrement sous forme de vapeur.

Dans le cas où le robinet 19 est ouvert et le robinet 21 fermé, le mélange gazeux est envoyé par l'intermédiaire d'un tube de pyrex 3' fixé à l'intérieur du tube 3 dans une disposition coaxiale et centrale et engagé à l'intérieur du tube 5 en Zircaloy. Un thermocouple 23 fixé sur un bouchon 22 de fermeture du tube 3' et suivant l'axe de ce tube permet de mesurer la température à l'intérieur du tube 5 en Zircaloy dans la zone de réaction chauffée par la bobine d'induction 7'.

Dans cette configuration, le dispositif permet de réaliser le revêtement intérieur du tube 5.

Dans le cas où le robinet 21 est ouvert et le robinet 19 fermé, le mélange gazeux pénètre directement à l'intérieur de l'enveloppe du tube 3 en pyrex et vient au contact de la surface extérieure d'une pièce introduite dans le tube 3 . Dans cette configuration, le dispositif permet de réaliser le revêtement extérieur des pastilles de combustible ou éventuellement du tube 5.

L'ensemble 4 de déplacement du tube 5 comporte un moteur 25 dont l'arbre de sortie traverse de manière étanche un couvercle de fermeture 26 du tube réacteur en pyrex 3 pour être relié au tube 5 en Zircaloy qui est fixé dans son prolongement. Le moteur 25 permet de mettre en rotation le tube 5 de Zircaloy autour de son axe de manière à obtenir un dépôt d'épaisseur et de composition homogène.

L'ensemble 4 comporte également un moteur 27 relié à un système à vis et écrou permettant de déplacer un support 28 sur lequel est fixé le moteur 25. Le support 28 est guidé en translation axiale par des barres 29 fixées dans la direction axiale sur l'ensemble de support 1.

Le support 28 mobile en translation axiale est solidaire du tube 5 de Zircaloy, par l'intermédiaire du moteur 25 et de son arbre de sortie.

Le moteur 27 permet de réaliser un déplacement en translation du tube 5 de Zircaloy à l'intérieur du réacteur en pyrex 3 de manière à présenter successivement les différentes zones du tube suivant sa longueur, au niveau de la zone de chauffage et de réaction correspondant au volume intérieur de la bobine d'induction 7'.

Pour réaliser un dépôt d'oxyde de chrome Cr₂O₃ sur la surface intérieure (ou extérieure) d'un tube en Zircaloy 4, on a utilisé, comme composé organométallique, de l'acétylacétonate de chrome.

Avant d'introduire le tube de Zircaloy 4 à l'intérieur du réacteur 3 en pyrex, on effectue un nettoyage soigné des surfaces de tube par une attaque chimique d'une durée de trente secondes dans un bain contenant de l'acide fluorhydrique, de l'acide nitrique et de l'eau. Le tube est ensuite rincé à l'eau distillée puis séché. Le décapage permet d'éliminer la couche d'oxyde de zirconium présente sur le tube, le zirconium étant un métal passivable. Les tubes en Zircaloy peuvent également être soumis à un polissage mécanique puis à un dégraissage à l'acétone avant d'être introduits dans le réacteur.

On effectue alors un balayage à l'argon du volume intérieur du réacteur avant d'y introduire le mélange réactionnel gazeux constitué d'argon, d'oxygène et de vapeur d'acétylacétonate de chrome.

L'acétylacétonate de chrome introduit dans l'étuve 2 est porté à une température de l'ordre de 180 à 200°C permettant sa vaporisation ; cette température permet d'autre part d'éviter toute décomposition de l'acétylacétonate de chrome.

De l'argon constituant le gaz vecteur est envoyé dans la capsule contenant la vapeur d'acétylacétonate de chrome pour réaliser l'entraînement de cette vapeur dans la canalisation 16. Une certaine proportion d'oxygène est ajoutée au mélange gazeux par l'intermédiaire du débitmètre 10 et de la canalisation 17.

Dans le cas où le robinet 19 est ouvert et le robinet 21 fermé, le mélange gazeux parvient à l'intérieur du tube 5 de Zircaloy, au niveau de la zone de chauffage constituée par la bobine d'induction 7'.

Il est possible soit d'alimenter la bobine d'induction 7' préalablement à l'envoi du gaz réactionnel, dès que le balayage en argon a été réalisé, soit d'alimenter la bobine 7' seulement après remplissage complet du tube réacteur 3 par le mélange réactionnel.

Dans tous les cas, le chauffage par induction présente l'avantage d'engendrer un dégagement de chaleur à l'intérieur même de la pièce dont on réalise le traitement et dans le cas présent, à l'intérieur de la paroi du tube 5. On évite ainsi de chauffer le mélange réactionnel à une température provoquant la décomposition et l'oxydation du composé organométallique de chrome, dans une zone éloignée de la paroi du tube de Zircaloy sur laquelle on effectue le revêtement. En particulier, on évite ainsi une décomposition et une oxydation du composé organométallique de chrome à son entrée dans le tube réacteur en pyrex 3.

En outre, le chauffage par induction présente une grande souplesse et permet d'obtenir des vitesses de chauffage élevées.

Dans le cas d'un tube en Zircaloy d'un diamètre extérieur de 9,5 mm, on a utilisé un tube réacteur en pyrex d'un diamètre de 20 mm et une bobine d'induction 7' d'une longueur de 60 mm; cette longueur correspond à la longueur de la zone réactionnelle dans laquelle on effectue le revêtement.

Comme il est visible sur les figures 3, 4 et 5, on a effectué différentes opérations de revêtement intérieur d'un tube en Zircaloy par de l'oxyde de chrome Cr₂O₃, en faisant varier les conditions opératoires dans lesquelles on réalise la décomposition et l'oxydation de l'acétylacétonate de chrome (C₅H₇O₂)₃-Cr. La décomposition thermique de l'acétylacétonate de chrome donne naissance à de la chromite Cr₂O₃ qui se dépose sous la forme d'une couche dense et homogène sur la surface du tube en Zircaloy porté à la température permettant la décomposition thermique, par chauffage par induction.

La figure 3 est un diagramme donnant les variations de la vitesse de dépôt de l'oxyde de chrome Cr₂O₃ en fonction de la température du substrat, c'est-à-dire de la température de la surface intérieure du tube en Zircaloy, pour deux températures différentes de vaporisation et de chauffage du composé organométallique de chrome.

La courbe inférieure correspond à une température de chauffage t = 180°C de l'acétylacétonate de chrome, à l'intérieur de l'étuve 2.

La courbe supérieure correspond à une température de chauffage t = 200°C de l'acétylacétonate de chrome.

Dans le cas de la courbe inférieure, la vitesse de dépôt du revêtement en oxyde de chrome Cr₂O₃ passe d'une valeur pratiquement nulle pour une température du substrat de 350°C à une valeur supérieure à 1 µm/h pour une température du substrat un peu inférieure à 600°C.

La courbe supérieure montre que la vitesse de dépôt du revêtement en chromite Cr₂O3 sur le Zircaloy 4 passe d'une valeur pratiquement nulle pour une température du substrat de 350°C à une valeur de l'ordre de 3 µm/h pour une température du substrat un peu inférieure à 600°C.

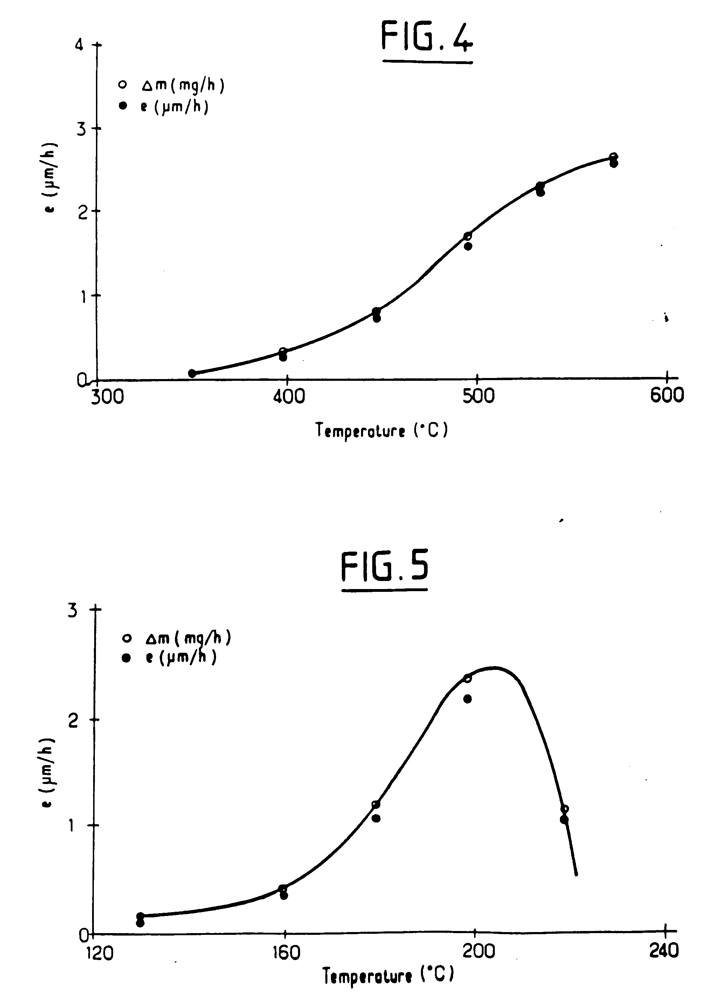

La figure 4 est un diagramme montrant les variations de la vitesse de dépôt du revêtement en oxyde de chrome Cr₂O₃, en fonction de la température du substrat, dans le cas où la pression du mélange réactionnel à l'intérieur du réacteur 3 est maintenue à une valeur sensiblement inférieure à la pression atmosphérique.

Dans ce cas, la vitesse de croissance de la couche d'oxyde de chrome passe d'une valeur pratiquement nulle pour une température du substrat de 350°C à une valeur un peu inférieure à 3 µm/h pour une température du substrat un peu inférieure à 600°C.

La figure 5 est un diagramme montrant les variations de la vitesse de dépôt de la couche d'oxyde de chrome en fonction de la température à laquelle est porté l'acétylacétonate de chrome, à l'intérieur de l'étuve 2.

La vitesse passe d'une valeur pratiquement nulle pour une température de l'acétylacétonate de chrome de 120°C à une valeur maximale supérieure à 2 µm/h, pour une valeur voisine de 200°C. La vitesse de réalisation du revêtement décroît ensuite très rapidement, ce qui permet de déterminer une valeur optimale pour la température de chauffage du composé organométallique.

La figure 5 est obtenue pour une température du substrat voisine de 500°C.

Les autres paramètres dont il est nécessaire de déterminer la valeur pour mettre en oeuvre le procédé de revêtement suivant l'invention sont le débit de gaz porteur (argon) et le débit du gaz oxydant (oxygène).

Des essais ont été effectués pour des débits de gaz porteurs (argon) allant de 0 à 8 litres/heure et pour des débits de gaz oxydant (oxygène) allant de 0 à 6 litres/heure.

On a pu montrer que le rapport des débits d'argon et d'oxygène pouvait varier dans de très larges proportions, le débit d'argon restant cependant toujours largement supérieur au débit d'oxygène. Ce rapport argon/oxygène a par exemple été fixé à la valeur 30 dans une première série d'opérations de revêtement et à la valeur 4 dans une seconde série d'opérations.

La vitesse de translation du tube de Zircaloy à l'intérieur du réacteur est fixée à une valeur de quelques centimètres/heure.

Dans tous les cas, le composé organométallique de chrome sous forme de vapeur est entraîné par le courant d'argon et mélangé à une certaine proportion d'oxygène. Le mélange réactionnel pénètre dans le réacteur à une température qui ne permet pas l'oxydation et la pyrolyse de l'acétylacétonate de chrome.

En revanche, lorsque le mélange réactionnel parvient au contact de la zone du tube de Zircaloy portée par induction à une température très nettement supérieure à la température du mélange réactionnel, l'oxydation, la pyrolyse et la formation de Cr₂O₃ se produisent au contact de la paroi en Zircaloy. Il se dépose sur cette paroi une couche dense, homogène et résistante d'oxyde de chrome Cr₂O₃. La croissance de cette couche se poursuit au cours du temps à une vitesse dépendant des conditions opératoires, comme il a été indiqué ci-dessus.

Il est tout-à-fait possible de déposer une couche dont l'épaisseur est très nettement supérieure à 5 µm et inférieure à 10 µm, sans que cette couche soit fragile.

Un tel résultat n'a jamais pu être obtenu par les procédés selon l'art antérieur.

A titre d'exemple, on a réalisé un revêtement d'une épaisseur un peu supérieure à 5 µm et inférieure à 10 µm, à l'intérieur d'un tube en Zircaloy dans les conditions suivantes :
température de l'acétylacétonate de chrome : 180°C,
température du substrat : 450°C,
rapport argon/oxygène = 30,
vitesse de translation du tube : 3 à 5 cm/h.

Dans ce cas, la vitesse de croissance du dépôt est de 0,8 µm/h, ce qui correspond sensiblement au point A du diagramme de la figure 3.

Le dépôt est uniforme et adhérent et constitué d'oxyde de chrome Cr2O3 à structure hexagonale, comme on a pu le mettre en évidence par diffraction de rayons X et par spectrométrie RAMAN. En outre, on a pu montrer l'homogénéité de composition dans l'épaisseur de la couche, par spectrométrie à décharge luminescente.

Il convient de noter que la vitesse de dépôt du revêtement en oxyde de chrome Cr2O3 dépend à la fois des caractéristiques de l'installation et du procédé de dépôt. Cette vitesse dépend en particulier du débit du composé organométallique sous forme de vapeur, de la température des gaz réactionnels au contact du substrat et de la pression de ces gaz (on a pu faire varier cette pression entre 1 millibar et 1030 millibars).

Il est également possible d'influer sur les conditions du dépôt en introduisant des gaz réducteurs tels que l'hydrogène dans le réacteur, ces gaz accélérant la décomposition du composé organométallique utilisé et en faisant intervenir un plasma produisant des espèces activées telles que des ions, des atomes ou des radicaux libres.

Indépendamment de ces influences diverses et extérieures aux conditions de mise en oeuvre du procédé lui-même, on a pu déterminer des conditions optimales pour la conduite du procédé de revêtement.

Ces conditions peuvent être définies ainsi : température de chauffage du composé organométallique : 190 à 200°C,
température du substrat : 500 à 600°C,
débit du gaz vecteur (argon) : 4 litres/heure,
débit d'oxygène : 1 litre/heure.

Ces conditions sont évidemment valables dans le cas du revêtement intérieur d'un tube de gainage en Zircaloy.

Dans les conditions définies ci-dessus, la vitesse de dépôt de la couche de revêtement en oxyde de chrome Cr2O3 est de l'ordre de 1.5 µm/h.

Pour éviter l'interaction pastilles-gaine des éléments combustibles, on peut effectuer un dépôt d'une couche de revêtement d'oxyde de chrome sur la surface latérale externe des pastilles de combustible nucléaire frittées sur une épaisseur inférieure à 10 µm en utilisant le procédé et le dispositif décrits ci-dessus. Les pastilles sont ensuite introduites dans une gaine en alliage de zirconium qui peut être ou non revêtue intérieurement par une couche d'oxyde de chrome.

Dans tous les cas, la couche en oxyde de chrome déposée, soit sur la surface intérieure de la gaine, soit sur la surface latérale des pastilles, soit à la fois sur la gaine et les pastilles permet de séparer de manière efficace et permanente le matériau combustible de la gaine, pendant l'utilisation de l'élément combustible dans le réacteur, ce qui permet d'éviter le phénomène d'interaction pastilles-gaine.

Il est bien évident que le procédé suivant l'invention ne se limite pas aux modes de réalisation qui ont été décrits.

C'est ainsi qu'on peut utiliser des composés organométalliques volatils différents de l'acétylacétonate de chrome (C5H7O2)3-Cr et par exemple des composés tels que RCr carbonyl et le trichlorotétrahydrofuranne chrome.

Il est bien évident que l'oxydation du composé organométallique de chrome peut être obtenue à partir d'un gaz oxydant différent de l'oxygène et par exemple à partir de vapeur d'eau ou de gaz carbonique.

Les gaines des éléments combustibles obtenus par le procédé suivant l'invention peuvent également comporter une couche externe anti-usure en oxyde de chrome réalisée par dépôt chimique en phase gazeuse à partir d'un composé organo-métallique.

## Revendications

1. Procédé de réalisation d'une couche d'isolation en oxyde de chrome entre les pastilles et la gaine (5) d'un élément combustible pour réacteur nucléaire comportant une gaine (5) en alliage de zirconium et un empilement de pastilles de matériau combustible fritté qui sont introduites dans la gaine (5) lors de la fabrication de l'élément combustible, caractérisé par le fait qu'on met en contact un composé organo-métallique de chrome sous forme gazeuse avec au moins un substrat constitué par la surface intérieure de la gaine (5) et/ou la surface extérieure des pastilles de combustible, en présence d'un gaz oxydant, pour réaliser un dépôt chimique en phase gazeuse d'oxyde de chrome sur le substrat maintenu à une température comprise entre 300 et 600°C.

2. Procédé suivant la revendication 1, caractérisé par le fait que le composé organométallique de chrome est de l'acétylacétonate de chrome (C5H7O2)3-Cr et que la température du substrat est comprise entre 350 et 600°C.

3. Procédé suivant la revendication 2, caractérisé par le fait que l'acétylacétonate de chrome est chauffé à une température comprise entre 180 et 200°C avant sa mise en contact avec le substrat.

4. Procédé suivant l'une quelconque des revendications 1 à 3, caractérisé par le fait que la vapeur du composé organométallique de chrome est entraînée par un gaz vecteur assurant sa mise en contact avec le substrat.

5. Procédé suivant la revendication 4, caractérisé par le fait que le gaz vecteur est de l'argon.

6. Procédé suivant l'une quelconque des revendications 4 et 5, caractérisé par le fait que le gaz oxydant est constitué par de l'oxygène mélangé en proportion déterminée au gaz vecteur et à la vapeur de composé organométallique.

7. Elément combustible pour réacteur nucléaire comportant une gaine (5) tubulaire en alliage de zirconium et un empilement de pastilles de matériau combustible fritté disposées à l'intérieur de la gaine (5), et qui comporte au moins une couche d'isolation intercalée entre la surface intérieure de la gaine (5) et la surface extérieure des pastilles située en vis-à-vis de la surface intérieure de la gaine (5), caractérisé en ce que la couche d'isolation est en oxyde de chrome d'une épaisseur inférieure à 10µm.

8. Elément combustible suivant la revendication 7, caractérisé par le fait que la couche d'isolation est déposée sur la surface intérieure de la gaine (5).

9. Elément combustible suivant la revendication 7, caractérisé par le fait que la couche d'isolation est déposée sur la surface extérieure des pastilles de matériau combustible.

10. Elément combustible suivant la revendication 7, caractérisé par le fait que la couche d'isolation est constituée à la fois par un revêtement déposé sur la surface intérieure de la gaine (5) et par un revêtement déposé sur la surface extérieure des pastilles.

11. Elément combustible suivant l'une quelconque des revendications 7 à 10, caractérisé par le fait que la gaine (5) est revêtue sur sa surface extérieure par une couche d'oxyde de chrome.

## Patentansprüche

1. Verfahren zum Herstellen einer Isolierschicht aus Chromoxid zwischen den Tabletten und der Schutzhülle (5) eines Brennelementes für einen Kernreaktor, mit einer Schutzhülle (5) aus Zirkoniumlegierung und einer Schichtung von Tabletten aus gesintertem Brennmaterial, die während der Herstellung des Brennelementes in die Schutzhülle (5) eingeführt werden, dadurch gekennzeichnet daß man eine organometallische Chromverbindung in Gasform mit wenigstens einem Substrat in Kontakt bringt, das aus der Innenfläche der Schutzhülle (5) und/oder der Außenfläche der Tabletten aus Brennmaterial gebildet ist, bei Anwesenheit eines oxidierenden Gases, um eine chemische Ablagerung von Chromoxid in gasförmiger Phase auf dem Substrat herzustellen, das auf einer Temperatur zwischen 300 und 600°C gehalten wird.

2. Verfahren nach Anspruch 1, dadurch gekennzeichnet, daß die organometallische Chromverbindung Chromacetylacetonat (C5H7O2)3-Cr ist und daß die Temperatur des Substrates zwischen 350 und 600°C liegt.

3. Verfahren nach Anspruch 2, dadurch gekennzeichnet, daß das Chromacetylacetonat vor seinem In-Kontakt-Bringen mit dem Substrat auf eine Temperatur zwischen 180 und 200°C erhitzt wird.

4. Verfahren nach einem der Ansprüche 1 bis 3, dadurch gekennzeichnet, daß der Dampf der organometallischen Verbindung durch ein Schleppgas getrieben wird, was das In-Kontakt-Bringen mit dem Substrat sicherstellt.

5. Verfahren nach Anspruch 4, dadurch gekennzeichnet, daß das Schleppgas Argon ist.

6. Verfahren nach einem der Ansprüche 4 und 5, dadurch gekennzeichnet, daß das oxidierende Gas aus Sauerstoff, gemischt in festgelegter Proportion mit dem Schleppgas und dem Dampf der organometallischen Verbindung, gebildet ist.

7. Brennelement für einen Kernreaktor, mit einer röhrenförmigen Schutzhülle (5) aus Zirkoniumlegierung und einer Schichtung aus Tabletten aus gesintertem Brennmaterial, die im Inneren der Schutzhülle (5) angeordnet sind, und das wenigstens eine Isolierschicht umfaßt, die zwischen der Innenfläche der Schutzhülle (5) und der Außenfläche der Tabletten, welche gegenüber der Innenfläche der Schutzhülle (5) angeordnet sind, gelegen ist, dadurch gekennzeichnet, daß die Isolierschicht aus Chromoxid einer Dicke geringer als 10 um besteht.

8. Brennelement nach Anspruch 7, dadurch gekennzeichnet, daß die Isolierschicht auf der Innenfläche der Schutzhülle (5) abgelagert ist.

9. Brennelement nach Anspruch 7, dadurch gekennzeichnet, daß die Isolierschicht auf der Außenfläche der Tabletten aus Brennmaterial abgelagert ist.

10. Brennelement nach Anspruch 7, dadurch gekennzeichnet, daß die Isolierschicht gleichzeitig durch einen Überzug, der auf der Innenfläche der Schutzhülle (5) abgelagert ist, und einen Überzug, der auf der Außenfläche der Tabletten abgelagert ist, gebildet ist.

11. Brennelement nach einem der Ansprüche 7 bis 10, dadurch gekennzeichnet, daß die Schutzhülle (5) auf ihrer Außenfläche mit einer Schicht aus Chromoxid überzogen ist.

## Claims

1. Process for producing a chromium oxide insulating layer between the pellets and the cladding (5) of a fuel element for a nuclear reactor having a zirconium alloy cladding (5) and a stack of pellets of sintered fuel material which are introduced into the cladding (5) during the manufacture of the fuel element, characterised in that an organo metallic chromium compound is brought into contact, in gaseous form, with at least one substrate consisting of the inner surface of the cladding (5) and/or the outer surface of the fuel pellets, in the presence of an oxidising gas, in order to produce chemical vapour deposition of chromium oxide on the substrate kept at a temperature of between 300 and 600°.

2. Process according to claim 1, characterised in that the organo metallic chromium compound is chromium acetylacetonate (C₅H₇O₂)₃-Cr, and that the temperature of the substrate is between 350 and 600°C.

3. Process according to claim 2, characterised in that the chromium acetylacetonate is heated to a temperature of between 180 and 200°C before being brought into contact with the substrate.

4. Process according to any one of claims 1 to 3, characterised in that the vapour of the organo metallic chromium compound is entrained by a vector gas ensuring its contact with the substrate.

5. Process according to claim 4, characterised in that the vector gas is argon.

6. Process according to any one of claims 4 and 5, characterised in that the oxidising gas consists of oxygen mixed in a given proportion with the vector gas and with the organo metallic compound vapour.

7. Fuel element for a nuclear reactor having a tubular zirconium alloy cladding (5) and a stack of pellets of sintered fuel material arranged inside the cladding (5), and having at least one insulating layer inserted between the inner surface of the cladding (5) and that outer surface of the pellets situated facing the inner surface of the cladding (5), characterised in that the insulating layer is a chromium oxide layer less that 10 µm thick.

8. Fuel element according to claim 7, characterised in that the insulating layer is deposited on the inner surface of the cladding (5).

9. Fuel element according to claim 7, characterised in that the insulating layer is deposited on the outer surface of the pellets of fuel material.

10. Fuel element according to claim 7, characterised in that the insulating layer consists of both a coating deposited on the inner surface of the cladding (5) and of a coating deposited on the outer surface of the pellets.

11. Fuel element according to any one of claims 7 to 10, characterised in that the cladding (5) is coated on its outer surface with a chromium oxide layer.
